# EUROPEAN PATENT SPECIFICATION

(11) **EP 1 348 777 B1**
(45) Date of publication and mention of the grant of the patent: **15.07.2009**
(21) Application number: 03007037.9
(22) Date of filing: 27.03.2003
(51) Int. Cl.: C23C 14/56

(54) **Vacuum deposition apparatus**
Vakuumbeschichtungsanlage
Appareil de dépôt sous vide

(30) Priority: 29.03.2002 JP 2002097490
(43) Date of publication of application: 01.10.2003
(73) Proprietor: Nidek Co., Ltd., Gamagori-shi, Aichi 443-0035 (JP)
(72) Inventor: Kawai, Tokuyoshi, Hazu, Aichi 444-0415 (JP); Miyabu, Kazuhito, Toyokawa-shi, Aichi 442-0845 (JP)
(74) Representative: Hofer, Dorothea

(56) References cited:
- EP-A- 0 987 700
- US-A- 2 975 753
- US-A- 4 036 171
- US-A- 5 174 881

## Description

### 1. Field of the Invention

The present invention relates to a vacuum deposition apparatus for performing film-coating.

### 2. Description of Related Art

Conventionally, there have been film-coating methods using a vacuum deposition (vapor-deposition) apparatus which deposits (vapor-deposits) deposition a material onto an object to form a film thereon, thereby bringing about a predetermined effect such as an anti-reflection effect or others. In the case where the deposition material is deposited by use of the vacuum deposition apparatus, at first, degassing operation is performed by preheating to remove gas generated from the deposition material in order to maintain a stable vacuum pressure and enhance the purity of a film to be formed. After completion of this degassing (preheating) operation, deposition operation is performed by additional heating to evaporate the deposition material to deposit on the object.

In the case where the conventional vacuum deposition apparatus is used to form a film on the object, a next film-coating operation is started after completion of a previous film-coating operation (the degassing operation and the deposition operation).

However, this sequence that the next film-coating operation is started after completion of the previous film-coating operation means that the next film-coating operation begins with the degassing operation again, reducing an operating efficiency. It is further conceivable to, during the previous film-coating operation, concurrently perform the degassing operation for a deposition material to be used for the next film-coating operation in order to enhance the operating efficiency. In the conventional vacuum deposition apparatus, however, the vacuum pressure varies depending on the gas generated during the degassing operation, which would affect the next film-coating operation. There is also a problem that material components under degassing come to be mixed in the film which is currently being formed.

From US 2,975,753 a vacuum coating apparatus can be taken which is arranged to form a thin film on a substrate by vacuum deposition using crucibles individually placed in two coating chambers.

From EP 0 987 700 Al a device of manufacturing optical recording medium, including a plurality of recording layer forming chambers can be taken for forming a recording layer on a substrate by vapor deposition on an organic pigment material, and evacuation devices connected to the recording layer forming chambers, respectively. An example is shown that two recording layer forming units and others are placed in a single recording layer forming chamber.

### SUMMARY OF THE INVENTION

The present invention has been made in view of the above circumstances and has as an object to overcome the above problems and to provide a vacuum deposition apparatus capable of performing a film-coating operation in a short time without damaging the quality of the coated film.

This object is solved by a vacuum deposition apparatus according to the independent claim 1.

### BRIEF DESCRIPTION OF THE DRAWINGS

The accompanying drawings, which are incorporated in and constitute a part of this specification illustrate an embodiment of the invention and, together with the description, serve to explain the objects, advantages and principles of the invention.

In the drawings,
Fig. 1 is a view showing the flow of a film-coating operation;
Fig. 2 is a side view of a releasing device;
Fig. 3A is a side view of a vacuum deposition apparatus;
Fig. 3B is a top view of the apparatus of Fig. 3A;
Fig. 4 is a view showing a state of a shielding roof seen from above in the vacuum deposition apparatus; and
Fig. 5 is a block diagram of a control system.

### DETAILED DESCRIPTION OF THE PREFERRED EMBODIMENTS

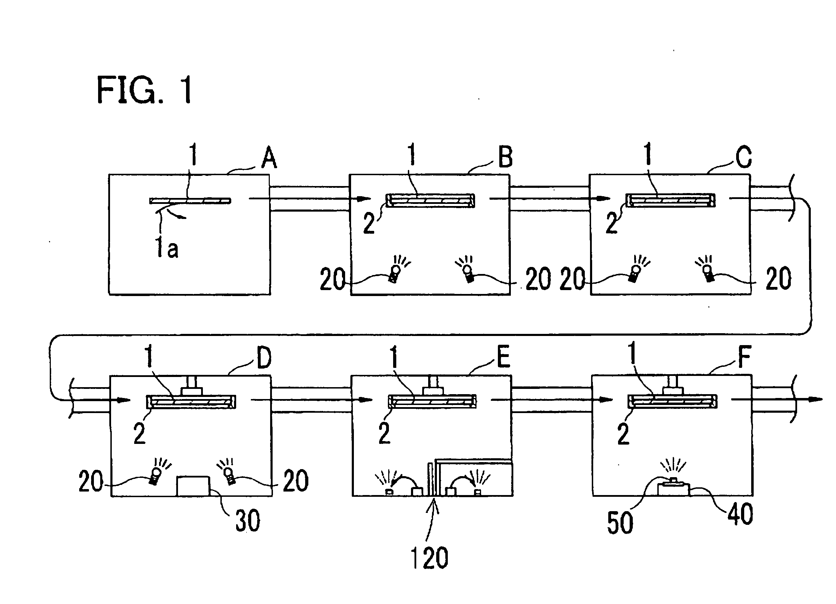

A detailed description of a preferred embodiment of a vacuum deposition apparatus embodying the present invention will now be given referring to the accompanying drawings. Fig. 1 is an explanatory view showing the flow of a film-coating operation in the present embodiment.

Reference alphabet A denotes a releasing chamber in which a protective film 1a is released from a polarizing plate 1. This polarizing plate 1 is an object onto which a deposition material will be applied. The release of the protective film 1a is performed by means of a releasing device which will be mentioned later. In the releasing chamber A, after the release of the protective film 1a, the polarizing plate 1 is set in a predetermined retaining frame 2. Reference alphabet B denotes a preheating chamber and C denotes a decompression chamber. The polarizing plate 1 is let stand for a predetermined time in the decompression chamber C and then conveyed to a pre-treatment chamber D where the plate 1 is subjected to a surface treatment using a plasma generator 30.

The polarizing plate 1 having been subjected to the surface treatment is conveyed to a deposition chamber E. In this chamber E, plural kinds of deposition materials (deposition agents) for a multi-layered anti-reflection film are deposited onto the polarizing plate 1 by vacuum deposition, thereby forming the anti-reflection film. After the formation of the anti-reflection film in the deposition chamber E, the polarizing plate 1 is conveyed to a post-treatment chamber F. In this chamber F, a film for water-repellent and stain-proof treatments is formed on the polarizing plate 1. After this post-treatment, the polarizing plate 1 is placed in a standby chamber not shown and the inside of this chamber is returned to atmospheric pressure. Thus, the film-coating operation is completed. The above sequence of operations is executed by the control part constructed of a sequencer mentioned later.

The operation chambers are isolated from one another by respective opening and closing doors not illustrated. The decompression chamber C, the pre-treatment chamber D, the deposition chamber E, and the post-treatment chamber F are connected to individual vacuum pumps whereby each inside of the chambers is reduced in pressure to a predetermined degree of vacuum.

Each operation is explained below.

### <Releasing operation>

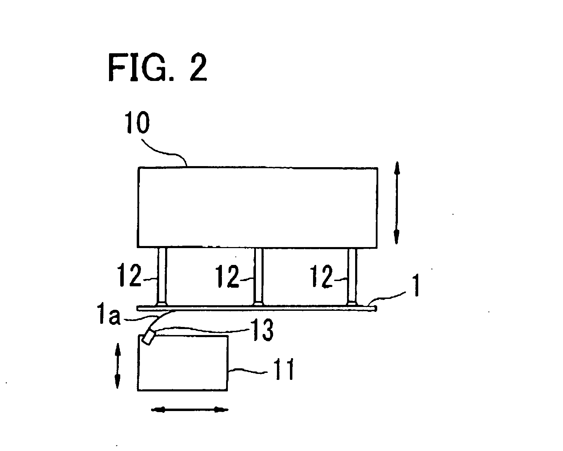

Fig. 2 is a side view showing a releasing device used in the releasing chamber A. This releasing device is mainly constructed of a lifting unit 10 for lifting up the polarizing plate 1 applied with the protective film 1a and placed in a predetermined position at a predetermined height and a releasing unit 11 for releasing the protective film 1a from the polarizing plate 1 lifted up to the predetermined height.

The lifting unit 10 is attached with a plurality of adsorbing members 12 arranged downward. Each adsorbing member 12 has a function of an air-pincette and has a suction passageway 2 therethrough for sucking air. By use of a suction pump not shown provided on the lifting unit 10, a negative pressure is caused in the tip end of the adsorbing member 12, thereby sucking and holding the polarizing plate 1.

Reference numeral 13 is an adhesion member provided in the releasing unit 11. This adhesion member 13 is constructed of an adhesive tape which can be rolled-up and a cutting part for cutting a part of the adhesive tape drawn out from the roll by a predetermined length. Further, the releasing unit 11 is arranged to be movable in a vertical direction and a lateral direction in Fig. 2 (a longitudinal direction of the polarizing plate 1).

The operation of releasing the protective film 1a from the polarizing plate 1 by means of the above constructed releasing device is explained below. The lift unit 10 is put in position above the polarizing plate 1 placed in a predetermined position and is moved downward to bring the tip ends of the adsorbing members 12 into contact with the polarizing plate 1, and then the adsorbing members 12 are operated to adsorb the plate 1. While the adsorbing members 12 adsorb the plate 1, the lift unit 10 is moved upward holding the polarizing plate 1 and moved to a position above the releasing unit 11. When the lift unit 10 is placed above the releasing unit 11, this releasing unit 11 draws out a part of the adhesive tape by a predetermined length and brings the drawn part of the tape into contact with an end of the polarizing plate 1. After the contact of the adhesive tape with the end of the plate 1, the releasing unit 11 is moved slightly downward, thereby partially releasing the protective film 1a from the polarizing plate 1. Subsequently, the releasing unit 11, of which the adhesive tape is being adhered to the part of the protective film 1a, is moved in the longitudinal direction of the polarizing plate 1 to completely release the protective film 1a from the polarizing plate 1. The releasing unit 11 then cuts the adhesive tape and throws down the released protective film 1a into a waste box or container not shown.

The polarizing plate 1, from which the protective film 1a has been removed, is carried as adsorbed and held by the adsorbing members 12 to a predetermined position where a retaining frame 2 is disposed. The polarizing plate 1 is then set in the retaining frame 2. This retaining frame 2 can mount therein the polarizing plates 1 in pairs. The polarizing plate 1 set in the retaining frame 2 is conveyed by conveying means such as a belt conveyor into the preheating chamber B where the subsequent operation is performed. The detailed structure of the retaining frame 2 will be mentioned later.

### <Preheating and Decompression operations>

The polarizing plate 1 conveyed into the preheating chamber B is heated by heating means 20 such as a halogen lamp provided in the preheating chamber B to a predetermined temperature (about 50°C) under atmospheric pressure (see Fig. 1). When the polarizing plate 1 is heated by the heating means 20, moisture, impurities, and others are taken out of the plate 1 and the plate 1 is degassed. The polarizing plate 1 heated for a predetermined time is conveyed by use of the conveying means into the decompressing chamber C, where the plate 1 is let stand under a predetermined reduced pressure (about 1.0×10⁻³ Pa) caused by a vacuum pump not shown. In this decompressing chamber C, the polarizing plate 1 is also heated by heating means 20.

Although a single decompressing chamber is used in the present embodiment, a plurality of decompressing chambers may be used for gradual decompression with respect to the polarizing plate 1. In this case, the plate 1 is exposed to a desired degree of vacuum in the last decompression chamber. Then, the polarizing plate 1 held in the desired degree of vacuum in the decompression chamber C is conveyed into the pre-treatment chamber D.

### <Pre-treatment operation>

The inside of the pre-treatment chamber D is controlled to have a substantially equal degree of vacuum to that in the decompression chamber C by a vacuum pump not shown. The polarizing plate 1 conveyed into the pre-treatment chamber D is moved to a center position in the chamber by means of rollers serving as carrying means not shown provided on inner side walls of the chamber. At a center of the ceiling of the chamber, there is provided holding means not shown for lifting both the polarizing plate 1 and the retaining frame 2. Accordingly, the polarizing plate 1 is lifted up together with the retaining frame 2 by the holding means. Then, the heating means 20 are driven to heat the polarizing plate 1 until the surface temperature thereof is raised to about 50°C to about 80°C. After that, the inside of the chamber is turned to a plasma atmosphere by a plasma generator 30.

After the plasma atmosphere is created in the chamber, the polarizing plate 1 is rotated in a horizontal direction by the holding means and the surface treatment operation by plasma with respect to the polarizing plate 1 is conducted for a predetermined period of time. When the surface treatment operation is completed, the polarizing plate 1 is conveyed into the deposition chamber E by means of the rollers.

### <Deposition operation>

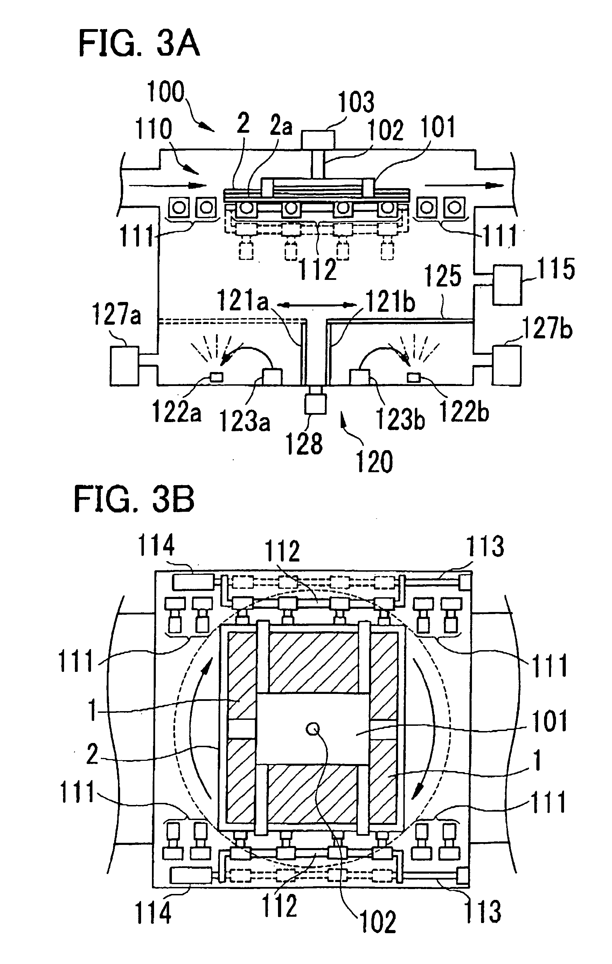

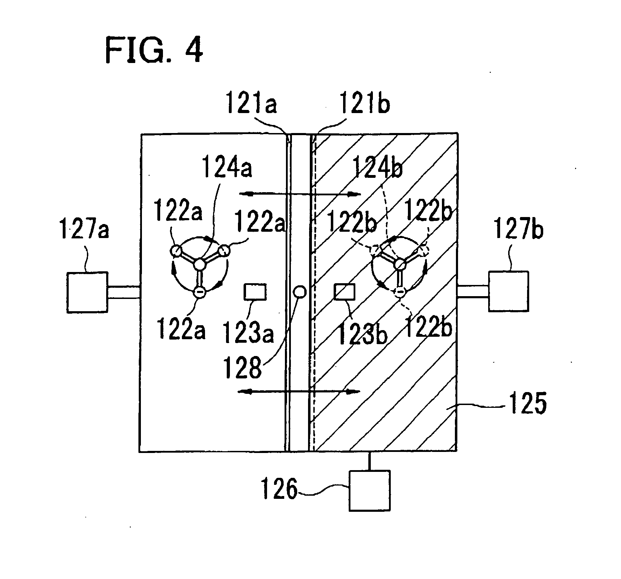

Figs. 3 and 4 schematically show the structure of the deposition chamber E. The deposition operation in this chamber E is explained below. Fig. 3A is a side view of the deposition chamber E and Fig. 3B is a top view of the rotating mechanism and the carrying mechanism provided inside the chamber E at its upper part.

As shown in Figs. 3A and 3B, at the upper part in the deposition chamber E, there are disposed a rotating mechanism 100 for rotating the polarizing plate 1 in a horizontal direction in the deposition chamber E and a carrying mechanism 110 for carrying the polarizing plate 1 set in the retaining frame 2 in or out from the chamber E.

The retaining frame 2 is constructed of a rectangular frame having a space in which two polarizing plates 1 can be held as shown Figs. 3A and 3B. This retaining frame 2 is formed, on its side surface, with a groove 2a. The frame 2 has no connecting member conventionally needed for carriage and rotation, achieving the reduction in weight.

The rotating mechanism 100 is engaged in the groove 2a formed on the side surface of the retaining frame 2. This rotating mechanism 100 is constructed of a holding part 101 which grips the frame 2 from both sides thereof, a shaft 102, and a driving part 103 constructed of a motor or the like. The holding part 101 is connected to the driving part 103 through the shaft 102. Thus, driving of the driving part 103 can cause the holding part 101 to rotate in a horizontal direction (in a direction indicated by an arrow in Fig. 3B).

The carrying mechanism 110 is constructed of first roller groups 111 fixedly attached onto the inner side walls of the chamber E at positions close to a carrying-in port and a carrying-out port respectively and second roller groups 112 movably attached onto the inner side walls between the roller groups 111 and 111 as shown in Figs. 3A and 3B. Each roller group 111 and 112 is constructed of a plurality of rollers and motors for driving the rollers. Each roller is caused to rotate by driving of each motor. The roller groups 111 and 112 are arranged in the deposition chamber E so that the retaining frame 2 conveyed therein can be placed on each roller without change in height position.

Reference numeral 113 is a shaft which is rotatably attached to the inner side wall of the chamber E and 114 is a driving part constructed of a motor. The roller group 112 is joined at its one end to the shaft 113 and at the other end to the driving part 114. Accordingly, prior to the rotation of the polarizing plate 1 by the rotating mechanism 110, each driving part 114 is driven to rotate, thereby withdrawing each corresponding roller group 112 from the horizontal position to a substantially vertical position (indicated by a dotted line in Figs. 3A and 3B). Reference numeral 115 is a vacuum pump for producing a substantial vacuum in the deposition chamber E.

Reference numeral 120 is a deposition mechanism capable of continuously performing deposition operations two or more times. This deposition mechanism 120 is configured so as to divide the floor space of the deposition chamber E by shielding walls 121a and 121b each having a predetermined height from the floor as shown Fig. 3A and Fig. 4. In the thus divided areas, there are disposed deposition sources 122a and 122b each constructed of a container made of metal which is filled with a deposition material or agent and electron beam generators 123a and 123b which irradiate electron beams to the deposition sources 122a and 122b respectively.

The deposition materials to be filled in the deposition sources 122a and 122b are commercially available deposition materials usable for forming an anti-reflective film, such as SiO₂, TiO₂, ZrO₂, Ta₂O₅, etc. The deposition sources 122a and 122b are arranged such that a plurality of deposition sources (three in each area in the present embodiment) are disposed in each area on the periphery of the same circle, namely, at circumferentially spaced intervals. Each deposition source is rotated by driving means 124a or 124b to move in a direction indicated by circumferential arrows in Fig. 4, so that each deposition source is placed at a position to which the electron beam emitted from the electron beam generator 123a or 123b is to be irradiated.

Reference numeral 125 denotes a shielding roof which is disposed at a position slightly higher than the height of the shielding walls 121a and 121b. This shielding roof 125 is movably arranged in a horizontal direction (in a lateral direction with respect to the drawing sheet of Fig. 4) in the deposition chamber E by means of driving means 126. The shielding roof 125 has a size (area) enough to entirely cover one of the two areas defined by the shielding walls 121a and 121b respectively. Accordingly, while the deposition material is evaporated from the deposition source disposed in one area, the shielding roof 125 covers the upper side of the deposition source disposed in the other area.

Reference numerals 127a and 127b are vacuum pumps, which are used in a degassing operation to degas the deposition materials in the deposition sources 122a and 122b. Reference numeral 128 is a film thickness sensor of a light projection type (light transmission type). The film thickness of the deposition materials deposited onto the polarizing plate 1 is determined based on a detection result by the sensor 128 which detects the thickness of a film formed on a monitor plate not shown provided in the retaining frame 2.

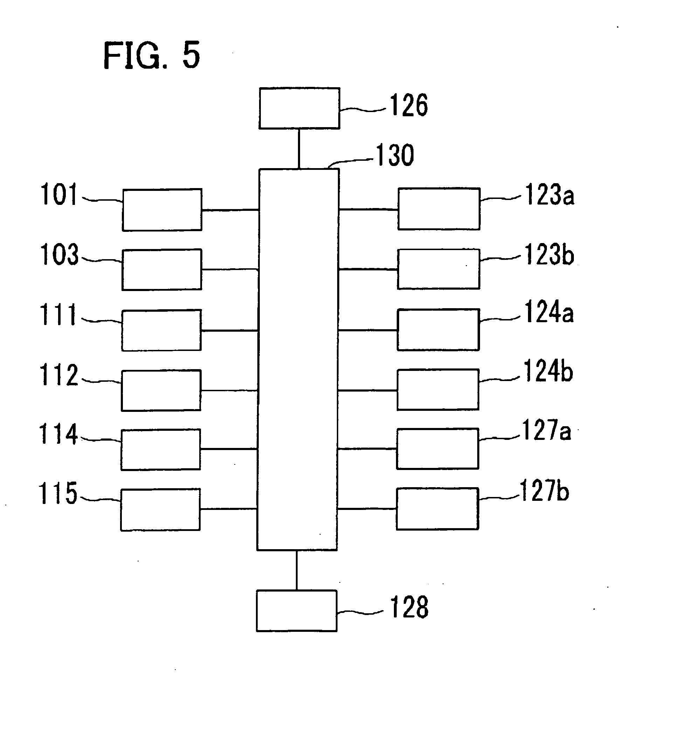

Next, the control of each driving mechanism in the deposition chamber E is shown in a block diagram of Fig. 5 and the deposition operation is explained below.

Reference numeral 130 denotes a control part constructed of a sequencer which performs the control of various driving mechanisms used in the deposition chamber E. This control part 130 also performs the control of driving mechanisms used in each operation chamber. The control part 130 previously drives the vacuum pumps 115, 127a, 127b to produce a substantial vacuum (about 1.0×10⁻² to 1.0×10⁻⁴ Pa) in the deposition chamber E. Successively, the control part 130 opens the opening and closing door not shown and drives the roller groups 111 and 112 to rotate respective rollers, thereby carrying the polarizing plate 1 set in the retaining frame 2 out of the pre-treatment chamber D and into the deposition chamber E. The carrying-in and carrying-out of the polarizing plate 1 by the roller groups are performed under condition that a frame part of the retaining frame 2 is put on the rollers.

After the carrying of the polarizing plate 1 in the deposition chamber E, the control part 130 continuously drives the rollers until the plate 1 is moved to a predetermined position (where the holding part 101 can grasp the frame 2). The position of the frame 2 is detected by a transmission fiber sensor, more specifically, it is detected when a taper pin formed in the holding part 101 is engaged in an unillustrated hole formed in the frame 2.

Upon detection that the frame 2 reaches the predetermined position, the control part 130 stops the driving of the roller groups 111 and 112. The control part 130 then drives the driving device 114 to withdraw the roller groups 112 to respective positions where the roller groups 112 will not interfere with the deposition operation. Simultaneously, the control part 130 causes the holding part 101 to grasp the retaining frame 2. After the withdrawal of the roller groups 112, the control part 130 drives the driving part 103 to horizontally rotate the polarizing plate 1 at a predetermined speed.

On the other hand, the control part 130 previously drives the driving device 126 to shift the shielding roof 125 to the area in which the deposition sources 122a are disposed (i.e., a left area in Fig. 3A). The control part 130 causes the electron beam generator 123a to emit an electron beam to the deposition source 122a, preliminarily heating the deposition material in the deposition source 122a at a predetermined temperature, thereby gasifying moisture and impurities which may interfere with deposition. The upper side of the deposition source 122a being covered by the shielding roof 125, the gas coming out of the deposition source 122a is prevented from moving upward, namely, toward the polarizing plate. The gas of which upward movement is restricted is discharged out of the chamber by operation of the vacuum pump 127a. After completion of the degassing operation, the control part 130 causes the shielding roof 125 to shift to the other area in which the deposition sources 122b are disposed (i.e., a right area in Fig. 3A) and simultaneously increases the output power of the electron beam to irradiate the deposition material in the deposition source 122a positioned in place, thereby allowing the deposition material to evaporate upward.

At this time, the polarizing plate 1 is being rotated by the rotating mechanism 100 at the predetermined speed in the upper position within the chamber. Thus, the deposition material evaporated from the deposition source 122a is uniformly deposited on each entire surface of the two polarizing plates 1 mounted in the retaining frame 2. The roller groups 112 are positioned outside a path of the corners of the frame 2 during rotation (corresponding to a circle shown by a dotted line in Fig- 3B) and will not interfere with the deposition operation. The retaining frame 2 is light in weight, which can eliminate the need to increase the size of the rotating mechanism 100 and the carrying mechanism 110. In addition, the retaining frame 2 can be carried and rotated rapidly.

Concurrently with execution of the deposition operation as above by use of the deposition source 122a with respect to the polarizing plates 1, the control part 130 drives the electron beam generator 123b to preliminarily heat the deposition source 122b at a predetermined temperature, thereby degassing the deposition material in the deposition source 122b.

After completion of the deposition operation from the deposition source 122a, the control part 130 shifts the shielding roof 125 to the area for the deposition source 122a (the left area in Fig. 3A), thereby opening the upper side of the area for the deposition source 122b. Sequentially, as in the case of the deposition source 122a, the deposition material in the deposition source 122b is evaporated. The control part 130 also drives the driving device 124 to rotate the deposition sources 122a to change their positions so that another deposition source 122a to be used for a next deposition operation is disposed in place for electron beam irradiation. After that, the identical operations to above are performed to preheat and degas the deposition material.

The above deposition operation does not any more require an additional time for a degassing operation and therefore can achieve a reduction of time needed for the deposition operation. With respect to the degree of vacuum in the entire deposition chamber, the areas in which the degassing operation is conducted are differentially pumped. Accordingly, the gas occurring during the degassing operation can be prevented from going around the shielding roof 125 toward the polarizing plate 1. In the deposition operation in the present embodiment, the deposition sources are arranged at two areas; however it is not limited thereto but the deposition sources may be arranged at more than two areas. In this case, those deposition sources are used by turns for allowing the deposition operation.

When the deposition operation is completely finished, the control part 130 returns the roller groups 112 to the horizontal positions and puts the retaining frame 2 on the rollers of the roller groups 112. Then, the control part 130 drives the roller groups 111 and 112 to carry the polarizing plate 1 to the subsequent chamber, i.e., the post-treatment chamber F.

### <Post-treatment operation>

In the post-treatment chamber F, the polarizing plate 1 having been applied with the anti-reflective film is subjected to a water-repellent treatment.

Specifically, the polarized plate 1 carried out of the deposition chamber E and into the post-treatment chamber F is grasped together with the retaining frame 2 at a predetermined position by means of a rotating mechanism 100 and a carrying mechanism 110 which are identical to those in the deposition chamber E, and is driven to horizontally rotate. On the floor of the post-treatment chamber F, there is disposed a heating part 40 constructed of a resistance heating element, in which a container 50 filled with a treatment material composed of a fluorine compound is disposed. The container 50 placed on the heating part 40 is heated at a predetermined temperature and the treatment material is thus evaporated to deposit on the polarizing plate 1 applied with the anti-reflective film. When this water-repellent treatment is finished, the sequence of operations fully comes to an end.

In the present embodiment, the object subjected to the deposition operation is a polarizing plate, but the present invention is not limited thereto. For example, the present invention can be applied to various types of objects such as a film, an acrylic plate, etc., in addition to the polarizing plate.

As described above, according to the present invention, while the deposition operation is performed using one deposition source, another deposition source is preliminarily heated. This makes it possible to reduce the time needed for deposition.

While the presently preferred embodiment of the present invention has been shown and described, it is to be understood that this disclosure is for the purpose of illustration and that various changes and modifications may be made without departing from the scope of the invention as set forth in the appended claims.

## Claims

1. A vacuum deposition apparatus which deposits a deposition material on an object (1) in a vacuum atmosphere, including:
an exhaust unit (115, 127a, 127b) which discharges gas from an inside of the apparatus;
a plurality of deposition units (122a, 122b, 123a, 123b, 124a, 124b) which evaporate the deposition material by heating to deposit the material on the object (1), each deposition unit being disposed in a separate chamber in the apparatus individually; and
an opening and closing unit (125, 126) which selectively opens and closes each chamber;
wherein the exhaust unit includes a first exhaust unit (127a, 127b) which selectively discharges the gas from an inside of each chamber,
wherein the exhaust unit further includes a second exhaust unit (115) which discharges the gas from an entire inside of the apparatus,
further including a control part (130) adapted to control each deposition unit so that a deposition unit is operated for preliminary heating while another deposition unit is operated for heating for deposition,
wherein the control part (130) is adapted to control the opening and closing unit (125, 126) to open the chamber in which the deposition unit which is operated for the heating for deposition is disposed and concurrently close the chamber in which the deposition unit which is operated for the preliminary heating is disposed, the first exhaust unit (127a, 127b) discharging the gas coming out of the deposition source (122a, 122b) out of the chamber.

## Patentansprüche

1. Vakuumabscheidungsgerät, das ein Abscheidungsmaterial auf einem Objekt (1) in einer Vakuumatmosphäre abscheidet, mit:
einer Abgaseinheit (115, 127a, 127b), die Gas von einer Innenseite des Gerätes ausgibt;
einer Mehrzahl von Abscheidungseinheiten (122a, 122b, 123a, 123b, 124a, 124b), die das Abscheidungsmaterial verdampfen durch Erwärmen zum Abscheiden des Materials auf dem Objekt (1), wobei jede Abscheidungseinheit in einer getrennten Kammer in dem Gerät individuell vorgesehen ist; und
einer öffnenden und schließenden Einheit (125, 126), die selektiv jede Kammer öffnet und schließt;
worin die Abgaseinheit eine erste Abgaseinheit (127a, 128b) enthält, die selektiv das Gas von einer Innenseite einer jeden Kammer ausgibt,
worin die Abgaseinheit weiter eine zweite Abgaseinheit (115) enthält, die Gas von einer gesamten Innenseite des Gerätes ausgibt,
weiter mit einem Steuerteil (130), das zum Steuern einer jeden Abscheidungseinheit so ausgelegt ist, dass eine Abscheidungseinheit zum vorläufigen Erwärmen betrieben wird, während eine andere Abscheidungseinheit zum Erwärmen zum Abscheiden betrieben wird,
worin das Steuerteil (130) ausgelegt ist zum Steuern der öffnenden und schließenden Einheit (125, 126) zum Öffnen der Kammer, in der die Abscheidungseinheit vorgesehen ist, die zum Erwärmen zum Abscheiden betrieben wird, und zum gleichzeitigen Schließen der Kammer, in der die Abscheidungseinheit vorgesehen ist, die zum vorläufigen Erwärmen betrieben wird, wobei die erste Abgaseinheit (127a, 127b) das Gas, das aus der Abscheidungsquelle (122a, 122b) herauskommt, aus der Kammer ausgibt.

## Revendications

1. Appareil de dépôt par évaporation sous vide qui dépose un matériau de dépôt sur un objet (1) dans une atmosphère sous vide, comprenant :
une unité d'évacuation (115, 127a, 127b) qui décharge le gaz d'un intérieur de l'appareil ;
une pluralité d'unités de dépôt (122a, 122b, 123a, 123b, 124a, 124b) qui évaporent le matériau de dépôt par chauffage afin de déposer le matériau sur l'objet (1), chaque unité de dépôt étant disposée dans une chambre séparée dans l'appareil individuellement ; et
une unité d'ouverture et de fermeture (125, 126) qui ouvre et ferme sélectivement chaque chambre ;
dans lequel l'unité d'évacuation comprend une première unité d'évacuation (127a, 127b) qui décharge sélectivement le gaz d'un intérieur de chaque chambre,
dans lequel l'unité d'évacuation comprend en outre une seconde unité d'évacuation (115) qui décharge le gaz de tout un intérieur de l'appareil,
comprenant en outre une partie de commande (130) adaptée pour commander chaque unité de dépôt de sorte qu'une unité de dépôt est actionnée pour le chauffage préliminaire, alors qu'une autre unité de dépôt est actionnée pour le chauffage pour le dépôt,
dans lequel la partie de commande (130) est adaptée pour commander l'unité d'ouverture et de fermeture (125, 126) pour ouvrir la chambre dans laquelle l'unité de dépôt qui est actionnée pour le chauffage pour le dépôt est disposée, et ferme simultanément la chambre dans laquelle l'unité de dépôt qui est actionnée pour le chauffage préliminaire est disposée, la première unité d'évacuation (127a, 127b) déchargeant le gaz sortant de la source de dépôt (122a, 122b) hors de la chambre.
